# EUROPEAN PATENT APPLICATION

(11) **EP 4 439 174 A1**
(43) Date of publication of application: **02.10.2024**
(21) Application number: 22898552.9
(22) Date of filing: 22.11.2022
(51) Int. Cl.: G03F 1/24, G03F 1/54, C23C 14/06

(54) **REFLECTIVE PHOTOMASK BLANK AND REFLECTIVE PHOTOMASK**

(30) Priority: 24.11.2021 JP 2021190273
(71) Applicant: Toppan Photomask Co., Ltd., Tokyo 108-0023 (JP)
(72) Inventor: MIYAWAKI, Daisuke, Tokyo 108-0023 (JP); SEKI, Kazunori, Tokyo 108-0023 (JP); NAKANO, Hideaki, Tokyo 108-0023 (JP)
(74) Representative: Hoffmann Eitle
(86) International application number: PCT/JP2022/043116
(87) International publication number: WO 2023/095769

(57) **Abstract**

An object of the present disclosure is to provide a reflective photomask blank and a reflective photomask having high transferability (particularly resolution) by making the most use of a phase shift effect. A reflective photomask blank (100) according to an aspect of the present disclosure includes a substrate (11), a reflective layer (12) having a multi-layer film structure, formed on the substrate (11), and configured to reflect an EUV light, a protective layer (13) formed on the reflective layer (12) and configured to protect the reflective layer (12), and an absorption layer (14) formed on the protective layer (13) and configured to absorb the EUV light, in which the absorption layer (14) has a phase difference in a range of 200 degrees or more and 280 degrees or less.

## Description

### Technical Field

The present disclosure relates to a reflective photomask blank and a reflective photomask.

### Background Art

In a manufacturing process of semiconductor devices, a demand for miniaturization by a photolithography technology has increased with the miniaturization of the semiconductor devices. The minimum development dimension of a transfer pattern in the photolithography largely depends on the wavelength of an exposure light source, and the minimum resolution dimension can be made smaller as the wavelength is shorter. Therefore, as the exposure light source in a manufacturing process of advanced semiconductor devices, an EUV (Extreme Ultraviolet) having a wavelength of 13.5 nm has been replaced with ArF excimer laser light of the related art having a wavelength of 193 nm.

Most materials have high light absorptivity to the EUV, and therefore a dioptric system utilizing light transmission of the related art cannot be used. Thus, an optical member of an exposure machine is not a lens but a mirror. A photomask is also a reflective EUV photomask in place of a transmission-type photomask of the related art. Incident light and reflected light on the EUV photomask cannot be coaxially designed. Thus, in the EUV lithography, a technique is commonly employed which includes making the EUV light incident by tilting the optical axis by 6° from the vertical direction of the EUV photomask and emitting reflected light reflected at an angle of -6° to a semiconductor substrate. However, the optical axis is tilted, causing a problem that deteriorates transfer performance due to a shadow of a pattern (absorption layer pattern) of the EUV photomask created by the EUV light incident to the EUV photomask. In the future, it is an object to improve transfer performance in order to perform further nanofabrication.

In a current EUV photomask, a film containing tantalum (Ta) as a main component having a film thickness of 60 to 90 nm is used as a light absorption layer. In a case where exposure of pattern transfer is performed with this EUV photomask, there is a risk of causing a reduction in contrast on an edge portion to be shadowed by the mask pattern, depending on a relationship between an incident direction and orientation of the mask pattern. Consequently, problems, such as an increase in line edge roughness of the transfer pattern on the semiconductor substrate and an inability to form a line width with a target dimension, occur, thereby deteriorating the transfer performance.

To solve this problem, a technique for suppressing an EUV reflectivity using a material having a high extinction coefficient k on an absorption layer [for example, see PTL 1] or a technique using a phase shift effect [for example, see PTL 2] has been proposed.

In a reflective phase shift mask, reflected light dimmed through the absorption layer has a phase difference with light that is reflected by an opening portion. Such a reflective phase shift mask uses the phase shift effect in the same manner as a transmission type phase shift mask, to improve contrast of an optical image on a wafer, and improve a resolution of the transfer pattern.

For example, in a reflective mask using the phase shift effect disclosed in PTL 2, an optimal value of the phase difference is set to 170 to 190 degrees. This is a value including 180 degrees, which is an optimal value of a phase difference of a transmission type phase shift mask of the related art.

However, in a case of the reflective mask, an EUV light is tilted and incident, and thus a portion of the reflected light passes through an edge portion of an absorption layer pattern. Since the reflected light that hits the edge portion has a phase deviated from the reflected light on a central portion of the pattern, the optimal phase difference of the absorption layer is different from 180 degrees. In other words, the present inventors have found that the optimal phase difference of the absorption layer in the reflective mask is a value different from "180 degrees" that has been used in a design concept of the related art.

As described above, in the reflective phase shift mask according to the related art, the phase shift effect cannot be sufficient utilized (used), and transferability (particularly resolution) thereof was not sufficient.

### Citation List

### Patent Literatures

PTL 1: WO 2018/159785
PTL 2: JP 6287099 B

### Summary of Invention

### Technical problem

An object of the present disclosure is to provide a reflective photomask blank and a reflective photomask having high transferability (particularly resolution) by making the most use of a phase shift effect.

### Solution to Problem

The present invention is made to solve the problems described above, and there is provided a reflective photomask blank according to the aspect of the present invention, including a substrate, a reflective layer having a multi-layer film structure, formed on the substrate, and configured to reflect an EUV light, a protective layer formed on the reflective layer and configured to protect the reflective layer, and an absorption layer formed on the protective layer and configured to absorb the EUV light, in which the absorption layer has a phase difference in a range of 200 degrees or more and 280 degrees or less.

In addition, in the reflective photomask blank according to the aspect of the present invention, the absorption layer may have a phase difference in a range of 215 degrees or more and 270 degrees or less.

In addition, in the reflective photomask blank according to the aspect of the present invention, the absorption layer may have a phase difference in a range of 230 degrees or more and 260 degrees or less.

In addition, in the reflective photomask blank according to the aspect of the present invention, the absorption layer may have a refractive index n with respect to the EUV light less than 0.93.

In addition, in the reflective photomask blank according to the aspect of the present invention, the absorption layer may have a refractive index n with respect to the EUV light less than 0.92.

In addition, in the reflective photomask blank according to the aspect of the present invention, the absorption layer may be configured with a material containing at least one or more elements of Ru, Rh, Mo, Pd, Ag, Pt, Au, Os, Ir, and Re.

In addition, in the reflective photomask blank according to the aspect of the present invention, the absorption layer may have a reflectivity with respect to the EUV light in a range of 2% or more and 20% or less.

In addition, in the reflective photomask blank according to the aspect of the present invention, the absorption layer may be configured with a material containing at least one or more elements of Pt, Au, Ir, and Re.

In addition, in the reflective photomask blank according to the aspect of the present invention, the absorption layer may be configured with a material containing at least one or more elements of Mo, W, Nb, Hg, Fe, Ta, V, Bi, Ti, Zr, Hf, C, B, Be, and Al.

There is provided a reflective photomask according to an aspect of the present invention, including a substrate, a reflective layer having a multi-layer film structure, formed on the substrate, and configured to reflect an EUV light, a protective layer formed on the reflective layer and configured to protect the reflective layer, and an absorption pattern layer formed on the protective layer, formed with a pattern, and configured to absorb the EUV light, in which the absorption pattern layer has a phase difference in a range of 200 degrees or more and 280 degrees or less.

In addition, in the reflective photomask according to the aspect of the present invention, the absorption pattern layer may have a phase difference in a range of 215 degrees or more and 270 degrees or less.

In addition, in the reflective photomask according to the aspect of the present invention, the absorption pattern layer may have a phase difference in a range of 230 degrees or more and 260 degrees or less.

In addition, in the reflective photomask according to the aspect of the present invention, the absorption pattern layer may have a refractive index n with respect to the EUV light less than 0.93.

In addition, in the reflective photomask according to the aspect of the present invention, the absorption pattern layer may have a refractive index n with respect to the EUV light less than 0.92.

In addition, in the reflective photomask according to the aspect of the present invention, the absorption pattern layer may be configured with a material containing at least one or more elements of Ru, Rh, Mo, Pd, Ag, Pt, Au, Os, Ir, and Re.

In addition, in the reflective photomask according to the aspect of the present invention, the absorption pattern layer may have a reflectivity with respect to the EUV light in a range of 2% or more and 20% or less.

In addition, in the reflective photomask according to the aspect of the present invention, the absorption pattern layer may be configured with a material containing at least one or more elements of Pt, Au, Ir, and Re.

In addition, in the reflective photomask according to the aspect of the present invention, the absorption pattern layer may be configured with a material containing at least one or more elements of Mo, W, Nb, Hg, Fe, Ta, V, Bi, Ti, Zr, Hf, C, B, Be, and Al.

### Advantageous Effects of Invention

According to the reflective photomask blank and the reflective photomask according to an aspect of the present disclosure, a sufficient phase shift effect is obtained, and wafer transfer performance (particularly resolution) can be improved.

### Brief Description of Drawings

FIG. 1 is a cross-sectional view illustrating a structure of a reflective photomask blank according to the present embodiment;
FIG. 2 is a cross-sectional view illustrating a structure of a reflective photomask according to the present embodiment;
FIG. 3 is a graph illustrating an optical constant of each metal material at a wavelength of an EUV light;
FIG. 4 is a schematic cross-sectional view illustrating a structure of a reflective photomask blank according to an example of the present invention;
FIG. 5 is a schematic cross-sectional view illustrating a manufacturing step of a reflective photomask according to an example of the present invention;
FIG. 6 is a schematic cross-sectional view illustrating a manufacturing step of a reflective photomask according to an example of the present invention;
FIG. 7 is a schematic cross-sectional view illustrating a manufacturing step of a reflective photomask according to an example of the present invention;
FIG. 8 is a schematic cross-sectional view illustrating a structure of a reflective photomask according to an example of the present invention;
FIG. 9 is a graph illustrating NILS of a reflective photomask according to an example of the present invention; and
FIG. 10 is a graph illustrating a phase difference of a reflective photomask according to an example of the present invention.

### Description of Embodiments

An embodiment of the present disclosure will be described with reference to the drawings.

Here, the configuration shown in the drawings is a schematic configuration, and a relationship between a thickness and a plane dimension, a proportion of a thickness of each layer, and the like are different from actual ones. In addition, embodiments shown below are examples of a configuration for implementing technical idea of the present disclosure and the technical idea of the present disclosure does not intend to limit materials, shapes, structures, and the like of constituent components to the following embodiments. The technical idea of the present disclosure may be modified in various manners within the technical scope specified by the claims described in the claims.

### (Configuration of reflective photomask blank and reflective photomask)

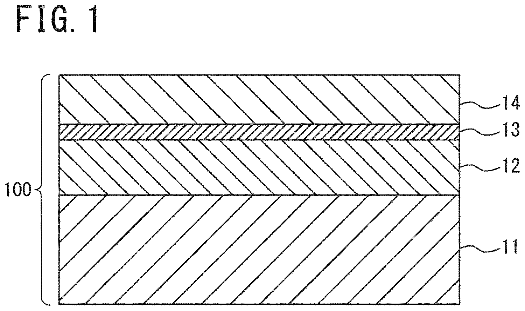

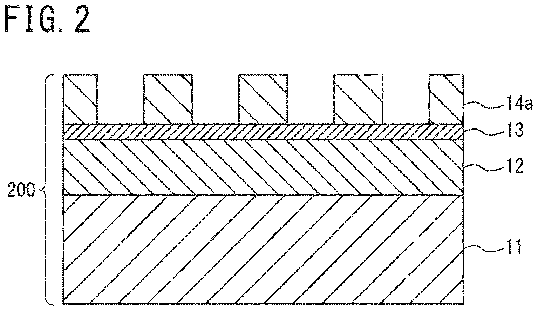

FIG. 1 is a schematic cross-sectional view illustrating a reflective photomask blank 100 according to an embodiment of the present invention. As illustrated in FIG. 1, the reflective photomask blank 100 according to the embodiment of the present invention includes a substrate 11, a reflective layer 12 formed on the substrate 11, a protective layer 13 formed on the reflective layer 12, and an absorption layer 14 formed on the protective layer 13. In addition, FIG. 2 is a schematic cross-sectional view illustrating a reflective photomask 200 according to the embodiment of the present invention. Here, the reflective photomask 200 according to the embodiment of the present invention illustrated in FIG. 2 is formed by patterning the absorption layer 14 of the reflective photomask blank 100 according to the embodiment of the present invention illustrated in FIG. 1. Hereinafter, each layer will be described in detail.

### (Substrate)

As the substrate 11 according to the embodiment of the present invention, for example, a flat Si substrate, a synthetic quartz substrate, or the like can be used. In addition, as the substrate 11, a low thermal expansion glass to which titanium is added can be used, however, the present embodiment is not limited thereto, as long as it is a material having a small thermal expansion coefficient.

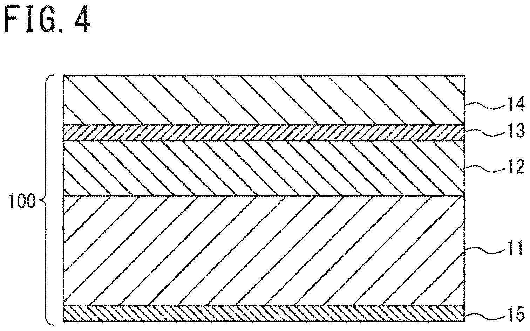

Further, as illustrated in FIG. 4 which will be described later, a back surface conductive film 15 can be formed on a surface of the substrate 11 on which the reflective layer 12 is not formed. The back surface conductive film 15 is a film for fixing the reflective photomask 200 using a principle of an electrostatic chuck when the reflective photomask 200 is installed in an exposure machine.

### (Reflective layer)

The reflective layer 12 according to the embodiment of the present invention may be any one as long as it reflects an EUV light (extreme ultraviolet light) which is an exposure light, and is a multi-layer reflective film (that is, an EUV light reflective film having a multi-layer film structure) obtained by a combination of materials having greatly different refractive indices with respect to the EUV light. The reflective layer 12 including the multi-layer reflective film may be formed by, for example, repeatedly depositing a layer of a combination of Mo (molybdenum) and Si (silicon) or Mo (molybdenum) and Be (beryllium) for about 40 cycles.

### (Protective layer)

The protective layer 13 according to the embodiment of the present invention is a layer which functions as an etching stopper for preventing damage to the reflective layer 12, in a case of forming an absorption pattern layer 14a by etching. The protective layer 13 may not be provided depending on a material of the reflective layer 12 or an etching condition. The protective layer 13 is formed of a material having resistance to dry etching performed when forming a pattern of the absorption layer 14. For example, a material of the protective layer 13 may be ruthenium (Ru).

### (Absorption layer and absorption pattern layer)

As illustrated in FIG. 1, the absorption layer 14 is a layer formed on the protective layer 13 and is a layer which absorbs the EUV light which is the exposure light. In addition, the absorption layer 14 is a layer which forms the absorption pattern layer (transfer pattern) 14a which is a nanofabrication pattern for transfer. That is, by removing a part of the absorption layer 14 of the reflective photomask blank 100, that is, by patterning the absorption layer 14, an absorption pattern (the absorption pattern layer 14a) of the reflective photomask 200 illustrated in FIG. 2 is formed.

In the part where the absorption layer 14 (the absorption pattern layer 14a) is formed, the EUV light is absorbed to reflect a part of light. Meanwhile, in an opening portion of the pattern (a portion without the absorption layer 14), the EUV light is reflected from the reflective layer 12 through the protective layer 13. The reflected light from the part where the absorption layer 14 is formed forms a desired phase difference from reflected light from the opening portion.

Generally, a reflectivity of the absorption layer 14 and the phase difference between the absorption layer 14 and the opening portion generated as a result of patterning are determined uniquely and can be obtained by calculation by optical theory, as long as an optical constant (a refractive index n, extinction coefficient k) and a film thickness of each layer of the reflective photomask blank and the reflective photomask, and a wavelength of light used are determined (for more details, for example, see Applied Physics Technology Selection 3, Sadafumi Yoshida, "Thin Films", Baifukan, 1990). In other words, the "phase difference" in the present embodiment refers to a difference between a phase of reflected light of the absorption layer 14 and a phase of reflected light (at an opening portion) of the reflective layer 12.

In the present embodiment, as each value of the refractive index n and the extinction coefficient k used in the calculation of the reflectivity and the phase difference, an actually measured value using the EUV light was used.

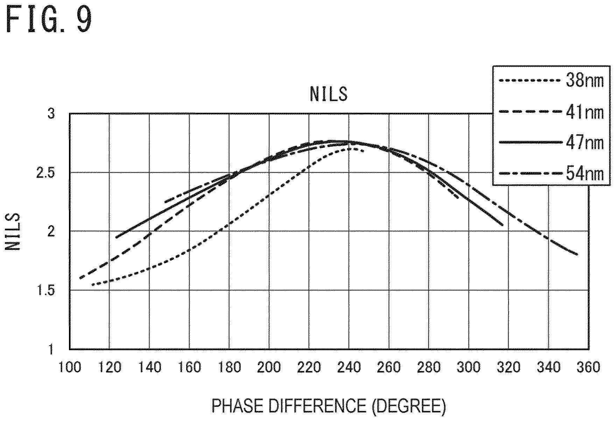

A normalized image log-slope (NILS) of a wafer pattern in a case where the wafer is transferred using the reflective photomask 200 depends on the phase difference of the reflective photomask 200. FIG. 9 is a graph in which, in a case where a hole pattern of 19 nm is exposed on the wafer by using the absorption layer 14 (the absorption pattern layer 14a) as a single film using a mixed material of rhodium (Rh) and aluminum (Al) under an exposure condition of an opening number NA of 0.33, the normalized image log-slope (NILS) is obtained at four levels of film thicknesses of 38 nm, 41 nm, 47 nm, and 54 nm. Rh has the refractive index n = 0.875 and the extinction coefficient k = 0.03, and Al has the refractive index n = 1.03 and the extinction coefficient k = 0.03, and accordingly, when the composition of RhAl is changed, the refractive index changes in a range of 0.875 < n < 1.03, and the extinction coefficient is constant at approximately k = 0.03. In addition, in a case of comparison with the same film thickness, the phase difference changes when the composition of RhAl is changed, that is, when the refractive index n is changed. In FIG. 9, a horizontal axis shows the phase difference, and a relationship with NILS is illustrated.

The normalized image log-slope (NILS) is a value of contrast obtained by NILS = w x dln (I)/dx... Equation (1), and becomes an index of a resolution of a wafer pattern when the wafer pattern is formed using the reflective photomask 200.

Here, "w" represents a line width and "I" represents an intensity of an energy latent image. The larger the value of NILS, the higher the resolution of the transfer pattern.

As illustrated in FIG. 9, there is a relationship between the phase difference and the NILS, and the NILS becomes maximum when the phase difference is in the vicinity of 230 degrees to 260 degrees.

In addition, as illustrated in FIG. 9, the value of NILS is 2.49 in a case where the film thickness is 54 nm and the phase difference of the absorption pattern layer 14a formed of RhAl is 180 degrees.

In contrast, the value of NILS is 2.60 in a case where the phase difference is 200 degrees, and the value of NILS is 2.60 in a case where the phase difference is 280 degrees. In both cases, the values thereof are higher by approximately 5% than in a case where the phase difference is 180 degrees.

In addition, the value of NILS is 2.68 in a case where the phase difference is 215 degrees, and the value of NILS is 2.67 in a case where the phase difference is 270 degrees. In both cases, the values thereof are higher by approximately 7% than in a case where the phase difference is 180 degrees.

Further, the value of NILS is 2.72 in a case where the phase difference is 230 degrees, and the value of NILS is 2.71 in a case where the phase difference is 260 degrees. In both cases, the values thereof are higher by approximately 9% than in a case where the phase difference is 180 degrees.

Furthermore, NILS is a maximum value, which is 2.74, in a case where the phase difference is 240 degrees, and the value thereof is higher by approximately 10% than in a case where the phase difference is 180 degrees.

As described above, compared to a case where the phase difference is 180 degrees, the NILS is improved by 5% or more when the phase difference is in a range of 200 degrees or more and 280 degrees or less, by 7% or more when the phase difference is in a range of 215 degrees or more and 270 degrees or less, or by 9% or more when the phase difference is in a range of 230 degrees or more and 260 degrees or less.

In addition, as illustrated in FIG. 9, the value of NILS is 2.76 in a case where the film thickness of the absorption pattern layer 14a is 47 nm and the phase difference is 240 degrees, and the value thereof is higher by approximately 12% than in a case where the phase difference is 180 degrees.

Further, as illustrated in FIG. 9, the value of NILS is 2.78 in a case where the film thickness of the absorption pattern layer 14a is 41 nm and the phase difference is 240 degrees, and the value thereof is higher by approximately 13% than in a case where the phase difference is 180 degrees.

Furthermore, as illustrated in FIG. 9, the value of NILS is 2.71 in a case where the film thickness of the absorption pattern layer 14a is 38 nm and the phase difference is 240 degrees, and the value thereof is higher by approximately 31% than in a case where the phase difference is 180 degrees.

From the above, in order to improve the resolution, the phase difference of the absorption layer 14 is preferably in a range of 200 degrees or more and 280 degrees or less, more preferably in a range of 215 degrees or more and 270 degrees or less, and most preferably in a range of 230 degrees or more and 260 degrees or less.

In the EUV lithography, the EUV light is obliquely incident and reflected by the reflective layer 12, however, the transfer performance onto the wafer (a semiconductor substrate) may deteriorate due to a shadowing effect that the absorption layer 14 (the absorption pattern layer 14a) obstructs an optical path. It is known that this deterioration in the transfer performance can be reduced by reducing a thickness of the absorption layer 14 that absorbs the EUV light.

A film thickness of the absorption layer 14 is preferably 60 nm or less. In a case where the film thickness of the absorption layer 14 is 60 nm or less, it is possible to sufficiently reduce the shadowing effect by compared to a Ta-based absorption film of the related art, and improve the transfer performance.

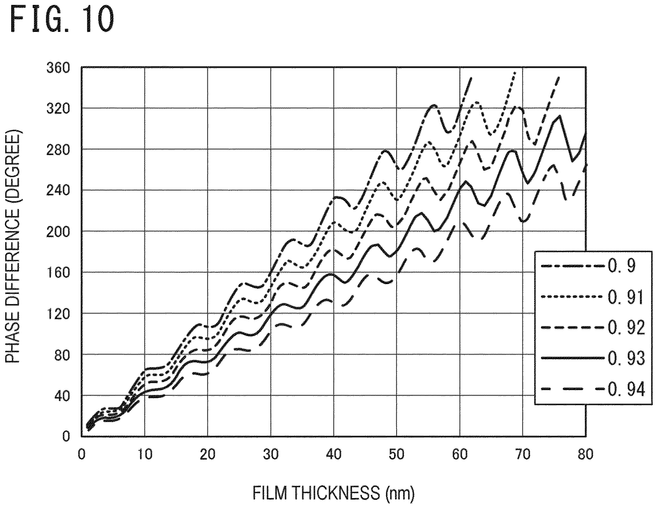

FIG. 10 is a graph in which, in a case where the refractive indices n of the absorption layer 14 with respect to the EUV light are 0.90, 0.91, 0.92, 0.93, and 0.94, a relationship between the film thickness and the phase difference of the absorption layer 14 is calculated by simulation.

As illustrated in FIG. 10, the smaller the refractive index n of the absorption layer 14 with respect to the EUV light, the thinner the film thickness for obtaining a desired phase difference. In a case where the refractive index n of the absorption layer 14 with respect to an EUV light is 0.93, a minimum film thickness for obtaining a phase difference of 230 to 260 degrees is 60 nm, which is substantially the same as the film thickness of the Ta-based absorption film of the related art. Therefore, it is preferable that the refractive index n of the absorption layer 14 with respect to the EUV light is less than 0.93, because the film thickness can be set to be thinner than 60 nm. In addition, it is more preferable that the refractive index n of the absorption layer 14 with respect to the EUV light is less than 0.92, because the minimum film thickness for obtaining a phase difference of 230 to 260 degrees is 50 nm or less.

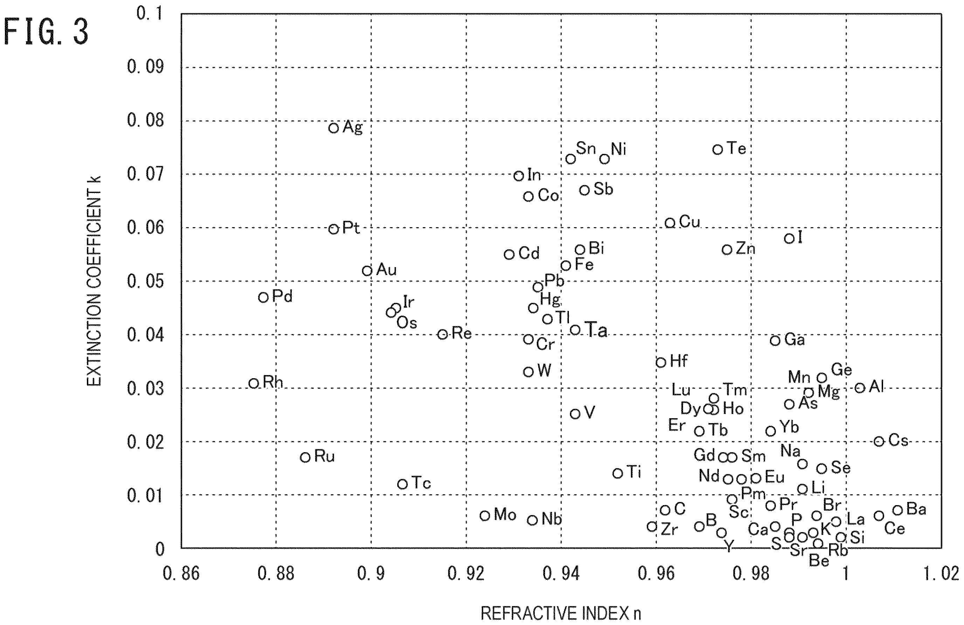

FIG. 3 is a graph illustrating an optical constant of each metal material with respect to a wavelength of 13.5 nm of the EUV light. In the graph of FIG. 3, a horizontal axis represents the refractive index n, and a vertical axis represents the extinction coefficient k. From FIG. 3, it is found that, since the refractive index n of each of Ru, Rh, Mo, Pd, Ag, Pt, Au, Os, Ir, and Re is less than 0.93, it is possible to reduce the shadowing effect by using a material group thereof. Hereinafter, "Ru, Rh, Mo, Pd, Ag, Pt, Au, Os, Ir, and Re" described above are defined as a "first material group" for convenience.

The material of the absorption layer 14 may be a mixture as long as it contains the elements of the first material group. In a case of the mixture, it is possible to control optical constants (the refractive index n and the extinction coefficient k) of the absorption layer 14 by changing the composition, and obtain desired phase difference and reflectivity. That is, the absorption layer 14 is preferably configured with a material containing at least one or more elements of Ru, Rh, Mo, Pd, Ag, Pt, Au, Os, Ir, and Re.

In addition to the first material group described above, the material of the absorption layer 14 may further contain at least one of tin (Sn), indium (In), tantalum (Ta), aluminum (Al), niobium (Nb), and titanium (Ti). In a case of an oxide, nitride, or oxynitride of Sn, In, and Ta, further improvement of heat resistance and improvement of processability of a conventional existing etching apparatus can be expected due to a high melting point. In addition, in a case of Al, Nb, and Ti, further improvement of washing resistance due to formation of a passive film can be expected.

Here, in a case where "Sn, In, Ta, Al, Nb, and Ti" described above are defined as a "second material group" for convenience, the absorption layer 14 may be configured with only the elements of the first material group, or may be configured with the elements of the first material group and the elements of the second material group. In addition, the absorption layer 14 may be configured with the elements of the first material group and elements other than the elements of the second material group, or may be configured with the elements of the first material group, the elements of the second material group, and elements other than the elements of the second material group. In a case where the absorption layer 14 is configured with the elements of the first material group and the elements of the second material group, a content ratio of the elements of the first material group is preferably 70 atom% or more, more preferably 80 atom% or more, and even more preferably 90 atom% or more of the elements of the entire absorption layer 14.

The material of the absorption layer 14 is preferably configured with a material containing at least one or more elements of Pt, Au, Ir, and Re. Pt, Au, Ir, and Re are materials, with which the improvement of processability of the etching apparatus of the related art can be expected among the first material group described above, and are materials having high resistance to hydrogen radical used in a case of cleaning the EUV exposure apparatus. In addition, since the refractive index n is less than 0.92, the shadowing effect can be expected to be reduced. Hereinafter, "Pt, Au, Ir, and Re" described above are defined as a "third material group" for convenience.

In addition to the third material group described above, the material of the absorption layer 14 may contain at least one of Mo, W, Nb, Hg, Fe, Ta, V, Bi, Ti, Zr, Hf, C, B, Be, and Al. Here, "Mo, W, Nb, Hg, Fe, Ta, V, Bi, Ti, Zr, Hf, C, B, Be, and Al" are defined as a "fourth material group". When the fourth material group is included, the improvement of the processability of the etching apparatus of the related art and the improvement of the resistance to hydrogen radical can be expected.

The absorption layer 14 may be configured with only the elements of the third material group, or may be configured with the elements of the third material group and the elements of the fourth material group. In addition, the absorption layer 14 may be configured with the elements of the third material group and elements other than the elements of the fourth material group, or may be configured with the elements of the third material group, the elements of the fourth material group, and elements other than the elements of the fourth material group. In a case where the absorption layer 14 is configured with the elements of the third material group and the elements of the fourth material group, a content ratio of the elements of the third material group is preferably 20 atom% or more of the elements of the entire absorption layer 14.

In order to obtain a sufficient phase shift effect, the reflectivity of the absorption layer 14 is preferably 1% or more and 30% or less and more preferably 2% or more and 20% or less in terms of an absolute reflectivity. Here, the "absolute reflectivity" refers to a value obtained by calculating light from a light source at a ratio of an amount of light reflected by an actual sample to a directly measured amount of light. In other words, it refers to a reflectivity when an intensity of the incident light is 100%. In the present embodiment, the term "absolute reflectivity" is used to distinguish it from "relative reflectivity" which refers to a ratio of a reflectivity (approximately 66%) of a multi-layer reflective layer (the reflective layer 12) to a reflectivity of the absorption layer 14. As described above, the "absolute reflectivity" in the present embodiment has a different concept from the "relative reflectivity".

In addition, a hard mask layer may be provided on the absorption layer 14. For the hard mask layer, a material having resistance to dry etching, such as a Cr-based film or a Si-based film, is used.

### [Examples]

Hereinafter, the present disclosure will be described in more detail with reference to examples, however, the present disclosure is not limited to examples.

### <Example 1>

A synthetic quartz substrate having low thermal expansion was used as the substrate illustrated in FIG. 4. 40 sheets of a multi-layer film of a pair of silicon (Si) and molybdenum (Mo), as a multi-layer reflective film, were deposited and formed on the substrate. A film thickness of the multi-layer reflective film was 280 nm.

Next, a capping layer (a protective layer) was formed on the multi-layer reflective film such that a film thickness is 3.5 nm using ruthenium (Ru). Accordingly, a reflective part including the multi-layer reflective film and the capping layer was formed on the substrate.

An absorption layer containing rhodium (Rh) and aluminum (Al) was formed on the capping layer such that a film thickness was 47 nm. An atomic number ratio of rhodium (Rh) and aluminum (Al) in the absorption layer was measured with X-ray photoelectron spectroscopy (XPS) and was 66:34. In addition, when crystallinity of the absorption layer was measured with an X-ray diffractometer (XRD), it was found to be amorphous although slight crystallinity was observed.

Next, a back surface conductive film was formed on a side of the substrate where no multi-layer reflective film was formed, to have a thickness of 100 nm using chromium nitride (CrN). The reflective photomask blank 100 was generated.

Each film was formed on the substrate using a multi-source sputtering apparatus. A film thickness of each film was controlled by a sputtering time.

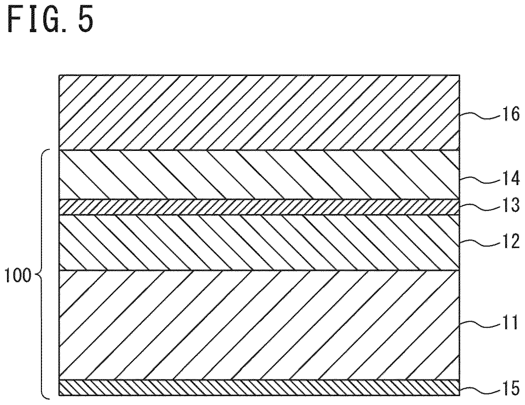

Next, a method for manufacturing the reflective photomask 200 will be described with reference to FIGS. 5 to 8. As illustrated in FIG. 5, a positive chemical amplification type resist (SEBP9012: manufactured by Shin-Etsu Chemical Co., Ltd.) was applied onto the absorption layer 14 of the reflective photomask blank 100 by spin coating to have a film thickness of 120 nm, and baked at 110°C for 10 minutes to form a resist film 16.

Next, a predetermined pattern was drawn on the resist film 16 with an electron beam drawing machine (JBX3030: manufactured by JEOL Ltd.).

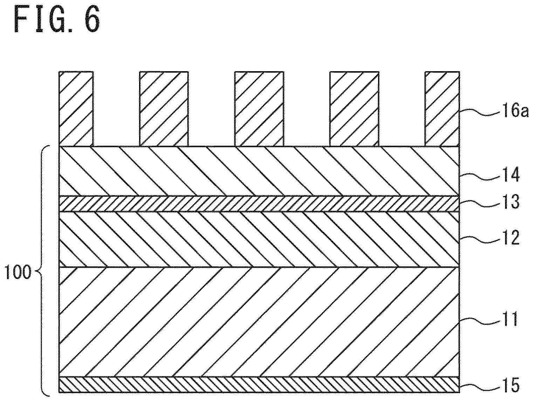

Then, pre-bake processing was performed at 110°C for 10 minutes, and development processing was performed using a spray development machine (SFG3000: manufactured by Sigmameltec Co., Ltd.). Accordingly, a resist pattern 16a was formed as illustrated in FIG. 6.

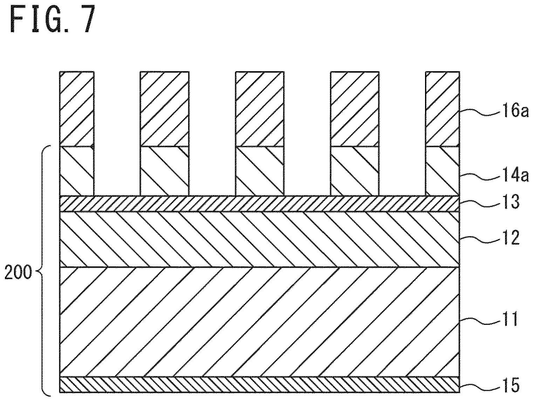

Next, using the resist pattern 16a as an etching mask, the absorption layer 14 was patterned by dry etching mainly using a chlorine-based gas. Accordingly, an absorption pattern (the absorption pattern layer) 14a was formed on the absorption layer 14 as illustrated in FIG. 7.

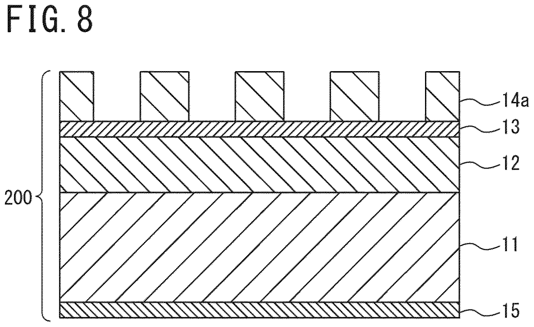

Next, the resist pattern 16a was peeled off to manufacture the reflective photomask 200 according to the present example, which is illustrated in FIG. 8.

In the present example, the absorption pattern 14a formed on the absorption layer 14 was a hole pattern with 76 nm on the reflective photomask 200 for transfer evaluation.

In Example 1 in which the formation was performed as described above, a refractive index and an extinction coefficient of the absorption layer were measured (actually measured) using an EUV light having a wavelength of 13.5 nm. As a result, the refractive index n and the extinction coefficient k of the absorption layer of Example 1 were n = 0.924 and k = 0.03, respectively.

Even for each of examples and comparative examples hereinafter, the refractive index and the extinction coefficient of the absorption layer were measured (actually measured) using an EUV light having a wavelength of 13.5 nm in the same manner as in Example 1.

In addition, an absolute reflectivity of the absorption layer at a wavelength of 13.5 nm was 3.4%, and a phase difference was 205 degrees.

### <Example 2>

A composition of RhAl, which is the material of the absorption layer, was changed to have an atomic number ratio of Rh:Al = 70:30 and a film was formed to have a film thickness of 47 nm. A reflective photomask of Example 2 was manufactured by the same method as in Example 1 except for the above.

The refractive index n and the extinction coefficient k of the absorption layer at a wavelength of 13.5 nm in Example 2, in which the formation was performed as described above, were n = 0.919 and k = 0.03, respectively.

In addition, the absolute reflectivity of the absorption layer at a wavelength of 13.5 nm was 3.7%, and the phase difference was 220 degrees.

### <Example 3>

A composition of RhAl, which is the material of the absorption layer, was changed to have an atomic number ratio of Rh:Al = 75:25 and a film was formed to have a film thickness of 47 nm. A reflective photomask of Example 3 was manufactured by the same method as in Example 1 except for the above.

The refractive index n and the extinction coefficient k of the absorption layer at a wavelength of 13.5 nm in Example 3, in which the formation was performed as described above, were n = 0.912 and k = 0.03, respectively.

In addition, the absolute reflectivity of the absorption layer at a wavelength of 13.5 nm was 4.3%, and the phase difference was 240 degrees.

### <Example 4>

A composition of RhAl, which is the material of the absorption layer, was changed to have an atomic number ratio of Rh:Al = 82:18 and a film was formed to have a film thickness of 47 nm. A reflective photomask of Example 4 was manufactured by the same method as in Example 1 except for the above.

The refractive index n and the extinction coefficient k of the absorption layer at a wavelength of 13.5 nm in Example 4, in which the formation was performed as described above, were n = 0.902 and k = 0.03, respectively.

In addition, the absolute reflectivity of the absorption layer at a wavelength of 13.5 nm was 5.3%, and the phase difference was 265 degrees.

### <Example 5>

A composition of RhAl, which is the material of the absorption layer, was changed to have an atomic number ratio of Rh:Al = 86:14 and a film was formed to have a film thickness of 47 nm. A reflective photomask of Example 5 was manufactured by the same method as in Example 1 except for the above.

The refractive index n and the extinction coefficient k of the absorption layer at a wavelength of 13.5 nm in Example 5, in which the formation was performed as described above, were n = 0.896 and k = 0.03, respectively.

In addition, the absolute reflectivity of the absorption layer at a wavelength of 13.5 nm was 5.9%, and the phase difference was 275 degrees.

### <Example 6>

A composition of RhAl, which is the material of the absorption layer, was changed to have an atomic number ratio of Rh:Al = 67:33 and a film was formed to have a film thickness of 54 nm. A reflective photomask of Example 6 was manufactured by the same method as in Example 1 except for the above.

The refractive index n and the extinction coefficient k of the absorption layer at a wavelength of 13.5 nm in Example 6, in which the formation was performed as described above, were n = 0.923 and k = 0.03, respectively.

In addition, the absolute reflectivity of the absorption layer at a wavelength of 13.5 nm was 2.6%, and the phase difference was 240 degrees.

### <Example 7>

A composition of RhAl, which is the material of the absorption layer, was changed to have an atomic number ratio of Rh:Al = 84:16 and a film was formed to have a film thickness of 41 nm. A reflective photomask of Example 7 was manufactured by the same method as in Example 1 except for the above.

The refractive index n and the extinction coefficient k of the absorption layer at a wavelength of 13.5 nm in Example 7, in which the formation was performed as described above, were n = 0.899 and k = 0.03, respectively.

In addition, the absolute reflectivity of the absorption layer at a wavelength of 13.5 nm was 4.4%, and the phase difference was 240 degrees.

### <Example 8>

A composition of RhAl, which is the material of the absorption layer, was changed to have an atomic number ratio of Rh:Al = 98:2 and a film was formed to have a film thickness of 38 nm. A reflective photomask of Example 8 was manufactured by the same method as in Example 1 except for the above.

The refractive index n and the extinction coefficient k of the absorption layer at a wavelength of 13.5 nm in Example 8, in which the formation was performed as described above, were n = 0.878 and k = 0.03, respectively.

In addition, the absolute reflectivity of the absorption layer at a wavelength of 13.5 nm was 9.2%, and the phase difference was 240 degrees.

### <Example 9>

The material of the absorption layer was changed to rhodium (Rh) and a film was formed to have a film thickness of 33 nm. A reflective photomask of Example 9 was manufactured by the same method as in Example 1 except for the above.

The refractive index n and the extinction coefficient k of the absorption layer at a wavelength of 13.5 nm in Example 9, in which the formation was performed as described above, were n = 0.875 and k = 0.03, respectively.

In addition, the absolute reflectivity of the absorption layer at a wavelength of 13.5 nm was 11.0%, and the phase difference was 240 degrees.

### <Example 10>

The material of the absorption layer was changed to a mixed material (RuNb) in which ruthenium (Ru) and niobium (Nb) were homogeneous at an atomic number ratio of 85:15, and a film was formed to have a film thickness of 44 nm. A reflective photomask of Example 10 was manufactured by the same method as in Example 1 except for the above.

The refractive index n and the extinction coefficient k of the absorption layer at a wavelength of 13.5 nm in Example 10, in which the formation was performed as described above, were n = 0.895 and k = 0.015, respectively.

In addition, the absolute reflectivity of the absorption layer at a wavelength of 13.5 nm was 17.0%, and the phase difference was 240 degrees.

### <Example 11>

The material of the absorption layer was changed to a mixed material (RuAl) in which ruthenium (Ru) and aluminum (Al) were homogeneous at an atomic number ratio of 59:41, and a film was formed to have a film thickness of 72 nm. A reflective photomask of Example 11 was manufactured by the same method as in Example 1 except for the above.

The refractive index n and the extinction coefficient k of the absorption layer at a wavelength of 13.5 nm in Example 11, in which the formation was performed as described above, were n = 0.940 and k = 0.023, respectively.

In addition, the absolute reflectivity of the absorption layer at a wavelength of 13.5 nm was 3.7%, and the phase difference was 240 degrees.

### <Example 12>

The material of the absorption layer was changed to a mixed material (SnRuO) in which tin oxide (SnO) and ruthenium (Ru) were homogeneous at an atomic number ratio of 20:80, and a film was formed to have a film thickness of 42 nm. A reflective photomask of Example 12 was manufactured by the same method as in Example 1 except for the above.

The refractive index n and the extinction coefficient k of the absorption layer at a wavelength of 13.5 nm in Example 12, in which the formation was performed as described above, were n = 0.896 and k = 0.03, respectively.

In addition, the absolute reflectivity of the absorption layer at a wavelength of 13.5 nm was 3.1%, and the phase difference was 240 degrees.

### <Example 13>

A film was formed by changing the film thickness of SnRuO of the absorption layer to 39 nm. A reflective photomask of Example 13 was manufactured by the same method as in Example 12 except for the above.

The refractive index n and the extinction coefficient k of the absorption layer at a wavelength of 13.5 nm in Example 13, in which the formation was performed as described above, were n = 0.896 and k = 0.03, respectively.

In addition, the absolute reflectivity of the absorption layer at a wavelength of 13.5 nm was 8.9%, and the phase difference was 225 degrees.

### <Example 14>

The material of the absorption layer was changed to a mixed material (InRuO) in which indium oxide (InO) and ruthenium (Ru) were homogeneous at an atomic number ratio of 15:85, and a film was formed to have a film thickness of 42 nm. A reflective photomask of Example 14 was manufactured by the same method as in Example 1 except for the above.

The refractive index n and the extinction coefficient k of the absorption layer at a wavelength of 13.5 nm in Example 14, in which the formation was performed as described above, were n = 0.895 and k = 0.03, respectively.

In addition, the absolute reflectivity of the absorption layer at a wavelength of 13.5 nm was 3.3%, and the phase difference was 240 degrees.

### <Example 15>

A film was formed by changing the film thickness of InRuO of the absorption layer to 39 nm. A reflective photomask of Example 15 was manufactured by the same method as in Example 14 except for the above.

The refractive index n and the extinction coefficient k of the absorption layer at a wavelength of 13.5 nm in Example 15, in which the formation was performed as described above, were n = 0.895 and k = 0.03, respectively.

In addition, the absolute reflectivity of the absorption layer at a wavelength of 13.5 nm was 9.3%, and the phase difference was 225 degrees.

### <Example 16>

The material of the absorption layer was changed to a mixed material (TaTi) in which tantalum (Ta) and titanium (Ti) were homogeneous at an atomic number ratio of 60:40, and a film was formed to have a film thickness of 78 nm. A reflective photomask of Example 16 was manufactured by the same method as in Example 1 except for the above.

The refractive index n and the extinction coefficient k of the absorption layer at a wavelength of 13.5 nm in Example 16, in which the formation was performed as described above, were n = 0.947 and k = 0.030, respectively.

In addition, the absolute reflectivity of the absorption layer at a wavelength of 13.5 nm was 1.2%, and the phase difference was 212 degrees.

### <Example 17>

The material of the absorption layer was changed to titanium (Ti) and a film was formed to have a film thickness of 80 nm. A reflective photomask of Example 17 was manufactured by the same method as in Example 1 except for the above.

The refractive index n and the extinction coefficient k of the absorption layer at a wavelength of 13.5 nm in Example 17, in which the formation was performed as described above, were n = 0.952 and k = 0.014, respectively.

In addition, the absolute reflectivity of the absorption layer at a wavelength of 13.5 nm was 6.5%, and the phase difference was 212 degrees.

### <Example 18>

The material of the absorption layer was changed to a mixed material (MoPd) in which molybdenum (Mo) and palladium (Pd) were homogeneous at an atomic number ratio of 40:60, and a film was formed to have a film thickness of 45 nm. A reflective photomask of Example 18 was manufactured by the same method as in Example 1 except for the above.

The refractive index n and the extinction coefficient k of the absorption layer at a wavelength of 13.5 nm in Example 18, in which the formation was performed as described above, were n = 0.896 and k = 0.03, respectively.

In addition, the absolute reflectivity of the absorption layer at a wavelength of 13.5 nm was 6.6%, and the phase difference was 235 degrees.

### <Example 19>

The material of the absorption layer was changed to platinum (Pt) and a film was formed to have a film thickness of 45 nm. A reflective photomask of Example 19 was manufactured by the same method as in Example 1 except for the above.

The refractive index n and the extinction coefficient k of the absorption layer at a wavelength of 13.5 nm in Example 19, in which the formation was performed as described above, were n = 0.890 and k = 0.06, respectively.

In addition, the absolute reflectivity of the absorption layer at a wavelength of 13.5 nm was 1.3%, and the phase difference was 243 degrees.

### <Example 20>

The material of the absorption layer was changed to a mixed material (IrPt) in which iridium (Ir) and platinum (Pt) were homogeneous at an atomic number ratio of 75:25, and a film was formed to have a film thickness of 45 nm. A reflective photomask of Example 20 was manufactured by the same method as in Example 1 except for the above.

The refractive index n and the extinction coefficient k of the absorption layer at a wavelength of 13.5 nm in Example 20, in which the formation was performed as described above, were n = 0.902 and k = 0.049, respectively.

In addition, the absolute reflectivity of the absorption layer at a wavelength of 13.5 nm was 2.2%, and the phase difference was 234 degrees.

### <Example 21>

The material of the absorption layer was changed to a mixed material (IrAu) in which iridium (Ir) and gold (Au) were homogeneous at an atomic number ratio of 40:60, and a film was formed to have a film thickness of 45 nm. A reflective photomask of Example 21 was manufactured by the same method as in Example 1 except for the above.

The refractive index n and the extinction coefficient k of the absorption layer at a wavelength of 13.5 nm in Example 21, in which the formation was performed as described above, were n = 0.901 and k = 0.049, respectively.

In addition, the absolute reflectivity of the absorption layer at a wavelength of 13.5 nm was 2.2%, and the phase difference was 234 degrees.

### <Example 22>

The material of the absorption layer was changed to a mixed material (RePt) in which rhenium (Re) and platinum (Pt) were homogeneous at an atomic number ratio of 75:25, and a film was formed to have a film thickness of 46 nm. A reflective photomask of Example 22 was manufactured by the same method as in Example 1 except for the above.

The refractive index n and the extinction coefficient k of the absorption layer at a wavelength of 13.5 nm in Example 22, in which the formation was performed as described above, were n = 0.909 and k = 0.045, respectively.

In addition, the absolute reflectivity of the absorption layer at a wavelength of 13.5 nm was 2.2%, and the phase difference was 240 degrees.

### <Example 23>

The material of the absorption layer was changed to a mixed material (ReAu) in which rhenium (Re) and gold (Au) were homogeneous at an atomic number ratio of 40:60, and a film was formed to have a film thickness of 45 nm. A reflective photomask of Example 23 was manufactured by the same method as in Example 1 except for the above.

The refractive index n and the extinction coefficient k of the absorption layer at a wavelength of 13.5 nm in Example 23, in which the formation was performed as described above, were n = 0.905 and k = 0.047, respectively.

In addition, the absolute reflectivity of the absorption layer at a wavelength of 13.5 nm was 2.8%, and the phase difference was 227 degrees.

### <Example 24>

The material of the absorption layer was changed to a mixed material (PtMo) in which platinum (Pt) and molybdenum (Mo) were homogeneous at an atomic number ratio of 20:80, and a film was formed to have a film thickness of 48 nm. A reflective photomask of Example 24 was manufactured by the same method as in Example 1 except for the above.

The refractive index n and the extinction coefficient k of the absorption layer at a wavelength of 13.5 nm in Example 24, in which the formation was performed as described above, were n = 0.918 and k = 0.017, respectively.

In addition, the absolute reflectivity of the absorption layer at a wavelength of 13.5 nm was 7.8%, and the phase difference was 213 degrees.

### <Example 25>

The material of the absorption layer was changed to a mixed material (PtMo) in which platinum (Pt) and molybdenum (Mo) were homogeneous at an atomic number ratio of 80:20, and a film was formed to have a film thickness of 45 nm. A reflective photomask of Example 25 was manufactured by the same method as in Example 1 except for the above.

The refractive index n and the extinction coefficient k of the absorption layer at a wavelength of 13.5 nm in Example 25, in which the formation was performed as described above, were n = 0.898 and k = 0.049, respectively.

In addition, the absolute reflectivity of the absorption layer at a wavelength of 13.5 nm was 2.2%, and the phase difference was 234 degrees.

### <Example 26>

The material of the absorption layer was changed to a mixed material (PtNb) in which platinum (Pt) and niobium (Nb) were homogeneous at an atomic number ratio of 35:65, and a film was formed to have a film thickness of 47 nm. A reflective photomask of Example 26 was manufactured by the same method as in Example 1 except for the above.

The refractive index n and the extinction coefficient k of the absorption layer at a wavelength of 13.5 nm in Example 26, in which the formation was performed as described above, were n = 0.919 and k = 0.024, respectively.

In addition, the absolute reflectivity of the absorption layer at a wavelength of 13.5 nm was 6%, and the phase difference was 214 degrees.

### <Example 27>

The material of the absorption layer was changed to a mixed material (PtNb) in which platinum (Pt) and niobium (Nb) were homogeneous at an atomic number ratio of 80:20, and a film was formed to have a film thickness of 45 nm. A reflective photomask of Example 27 was manufactured by the same method as in Example 1 except for the above.

The refractive index n and the extinction coefficient k of the absorption layer at a wavelength of 13.5 nm in Example 27, in which the formation was performed as described above, were n = 0.900 and k = 0.049, respectively.

In addition, the absolute reflectivity of the absorption layer at a wavelength of 13.5 nm was 2.2%, and the phase difference was 234 degrees.

### <Example 28>

The material of the absorption layer was changed to a mixed material (AuMo) in which gold (Au) and molybdenum (Mo) were homogeneous at an atomic number ratio of 25:75, and a film was formed to have a film thickness of 49 nm. A reflective photomask of Example 28 was manufactured by the same method as in Example 1 except for the above.

The refractive index n and the extinction coefficient k of the absorption layer at a wavelength of 13.5 nm in Example 28, in which the formation was performed as described above, were n = 0.918 and k = 0.018, respectively.

In addition, the absolute reflectivity of the absorption layer at a wavelength of 13.5 nm was 7.6%, and the phase difference was 209 degrees.

### <Example 29>

The material of the absorption layer was changed to a mixed material (AuMo) in which gold (Au) and molybdenum (Mo) were homogeneous at an atomic number ratio of 95:5, and a film was formed to have a film thickness of 39 nm. A reflective photomask of Example 29 was manufactured by the same method as in Example 1 except for the above.

The refractive index n and the extinction coefficient k of the absorption layer at a wavelength of 13.5 nm in Example 29, in which the formation was performed as described above, were n = 0.900 and k = 0.050, respectively.

In addition, the absolute reflectivity of the absorption layer at a wavelength of 13.5 nm was 2.7%, and the phase difference was 228 degrees.

### <Example 30>

The material of the absorption layer was changed to a mixed material (AuNb) in which gold (Au) and niobium (Nb) were homogeneous at an atomic number ratio of 45:55, and a film was formed to have a film thickness of 48 nm. A reflective photomask of Example 30 was manufactured by the same method as in Example 1 except for the above.

The refractive index n and the extinction coefficient k of the absorption layer at a wavelength of 13.5 nm in Example 30, in which the formation was performed as described above, were n = 0.918 and k = 0.026, respectively.

In addition, the absolute reflectivity of the absorption layer at a wavelength of 13.5 nm was 4.5%, and the phase difference was 213 degrees.

### <Example 31>

The material of the absorption layer was changed to a mixed material (AuNb) in which gold (Au) and niobium (Nb) were homogeneous at an atomic number ratio of 90:10, and a film was formed to have a film thickness of 45 nm. A reflective photomask of Example 31 was manufactured by the same method as in Example 1 except for the above.

The refractive index n and the extinction coefficient k of the absorption layer at a wavelength of 13.5 nm in Example 31, in which the formation was performed as described above, were n = 0.903 and k = 0.047, respectively.

In addition, the absolute reflectivity of the absorption layer at a wavelength of 13.5 nm was 2.2%, and the phase difference was 234 degrees.

### <Example 32>

The material of the absorption layer was changed to a mixed material (AuTi) in which gold (Au) and titanium (Ti) were homogeneous at an atomic number ratio of 65:35, and a film was formed to have a film thickness of 47 nm. A reflective photomask of Example 32 was manufactured by the same method as in Example 1 except for the above.

The refractive index n and the extinction coefficient k of the absorption layer at a wavelength of 13.5 nm in Example 32, in which the formation was performed as described above, were n = 0.918 and k = 0.039, respectively.

In addition, the absolute reflectivity of the absorption layer at a wavelength of 13.5 nm was 1.3%, and the phase difference was 225 degrees.

### <Example 33>

The material of the absorption layer was changed to a mixed material (AuTi) in which gold (Au) and titanium (Ti) were homogeneous at an atomic number ratio of 85:15, and a film was formed to have a film thickness of 46 nm. A reflective photomask of Example 33 was manufactured by the same method as in Example 1 except for the above.

The refractive index n and the extinction coefficient k of the absorption layer at a wavelength of 13.5 nm in Example 33, in which the formation was performed as described above, were n = 0.907 and k = 0.046, respectively.

In addition, the absolute reflectivity of the absorption layer at a wavelength of 13.5 nm was 2.2%, and the phase difference was 240 degrees.

### <Example 34>

The material of the absorption layer was changed to a mixed material (AuZr) in which gold (Au) and zirconium (Zr) were homogeneous at an atomic number ratio of 70:30, and a film was formed to have a film thickness of 51 nm. A reflective photomask of Example 34 was manufactured by the same method as in Example 1 except for the above.

The refractive index n and the extinction coefficient k of the absorption layer at a wavelength of 13.5 nm in Example 34, in which the formation was performed as described above, were n = 0.917 and k = 0.038, respectively.

In addition, the absolute reflectivity of the absorption layer at a wavelength of 13.5 nm was 2.1%, and the phase difference was 218 degrees.

### <Example 35>

The material of the absorption layer was changed to a mixed material (AuZr) in which gold (Au) and zirconium (Zr) were homogeneous at an atomic number ratio of 90:10, and a film was formed to have a film thickness of 46 nm. A reflective photomask of Example 35 was manufactured by the same method as in Example 1 except for the above.

The refractive index n and the extinction coefficient k of the absorption layer at a wavelength of 13.5 nm in Example 35, in which the formation was performed as described above, were n = 0.905 and k = 0.047, respectively.

In addition, the absolute reflectivity of the absorption layer at a wavelength of 13.5 nm was 2.5%, and the phase difference was 248 degrees.

### <Example 36>

The material of the absorption layer was changed to a mixed material (IrMo) in which iridium (Ir) and molybdenum (Mo) were homogeneous at an atomic number ratio of 30:70, and a film was formed to have a film thickness of 49 nm. A reflective photomask of Example 36 was manufactured by the same method as in Example 1 except for the above.

The refractive index n and the extinction coefficient k of the absorption layer at a wavelength of 13.5 nm in Example 36, in which the formation was performed as described above, were n = 0.918 and k = 0.018, respectively.

In addition, the absolute reflectivity of the absorption layer at a wavelength of 13.5 nm was 7.6%, and the phase difference was 209 degrees.

### <Example 37>

The material of the absorption layer was changed to a mixed material (IrMo) in which iridium (Ir) and molybdenum (Mo) were homogeneous at an atomic number ratio of 90:10, and a film was formed to have a film thickness of 45 nm. A reflective photomask of Example 37 was manufactured by the same method as in Example 1 except for the above.

The refractive index n and the extinction coefficient k of the absorption layer at a wavelength of 13.5 nm in Example 37, in which the formation was performed as described above, were n = 0.907 and k = 0.041, respectively.

In addition, the absolute reflectivity of the absorption layer at a wavelength of 13.5 nm was 3.7%, and the phase difference was 227 degrees.

### <Example 38>

The material of the absorption layer was changed to a mixed material (IrW) in which iridium (Ir) and tungsten (W) were homogeneous at an atomic number ratio of 50:50, and a film was formed to have a film thickness of 47 nm. A reflective photomask of Example 38 was manufactured by the same method as in Example 1 except for the above.

The refractive index n and the extinction coefficient k of the absorption layer at a wavelength of 13.5 nm in Example 38, in which the formation was performed as described above, were n = 0.919 and k = 0.039, respectively.

In addition, the absolute reflectivity of the absorption layer at a wavelength of 13.5 nm was 1.3%, and the phase difference was 225 degrees.

### <Example 39>

The material of the absorption layer was changed to a mixed material (IrW) in which iridium (Ir) and tungsten (W) were homogeneous at an atomic number ratio of 90:10, and a film was formed to have a film thickness of 46 nm. A reflective photomask of Example 39 was manufactured by the same method as in Example 1 except for the above.

The refractive index n and the extinction coefficient k of the absorption layer at a wavelength of 13.5 nm in Example 39, in which the formation was performed as described above, were n = 0.908 and k = 0.044, respectively.

In addition, the absolute reflectivity of the absorption layer at a wavelength of 13.5 nm was 2.2%, and the phase difference was 240 degrees.

### <Example 40>

The material of the absorption layer was changed to a mixed material (IrNb) in which iridium (Ir) and niobium (Nb) were homogeneous at an atomic number ratio of 50:50, and a film was formed to have a film thickness of 47 nm. A reflective photomask of Example 40 was manufactured by the same method as in Example 1 except for the above.

The refractive index n and the extinction coefficient k of the absorption layer at a wavelength of 13.5 nm in Example 40, in which the formation was performed as described above, were n = 0.920 and k = 0.025, respectively.

In addition, the absolute reflectivity of the absorption layer at a wavelength of 13.5 nm was 6%, and the phase difference was 214 degrees.

### <Example 41>

The material of the absorption layer was changed to a mixed material (IrNb) in which iridium (Ir) and niobium (Nb) were homogeneous at an atomic number ratio of 90:10, and a film was formed to have a film thickness of 46 nm. A reflective photomask of Example 41 was manufactured by the same method as in Example 1 except for the above.

The refractive index n and the extinction coefficient k of the absorption layer at a wavelength of 13.5 nm in Example 41, in which the formation was performed as described above, were n = 0.908 and k = 0.041, respectively.

In addition, the absolute reflectivity of the absorption layer at a wavelength of 13.5 nm was 3.1%, and the phase difference was 237 degrees.

### <Example 42>

The material of the absorption layer was changed to a mixed material (IrTa) in which iridium (Ir) and tantalum (Ta) were homogeneous at an atomic number ratio of 85:15, and a film was formed to have a film thickness of 45 nm. A reflective photomask of Example 42 was manufactured by the same method as in Example 1 except for the above.

The refractive index n and the extinction coefficient k of the absorption layer at a wavelength of 13.5 nm in Example 42, in which the formation was performed as described above, were n = 0.911 and k = 0.044, respectively.

In addition, the absolute reflectivity of the absorption layer at a wavelength of 13.5 nm was 2.8%, and the phase difference was 219 degrees.

### <Example 43>

The material of the absorption layer was changed to a mixed material (IrTa) in which iridium (Ir) and tantalum (Ta) were homogeneous at an atomic number ratio of 95:5, and a film was formed to have a film thickness of 46 nm. A reflective photomask of Example 43 was manufactured by the same method as in Example 1 except for the above.

The refractive index n and the extinction coefficient k of the absorption layer at a wavelength of 13.5 nm in Example 43, in which the formation was performed as described above, were n = 0.907 and k = 0.045, respectively.

In addition, the absolute reflectivity of the absorption layer at a wavelength of 13.5 nm was 2.5%, and the phase difference was 248 degrees.

### <Example 44>

The material of the absorption layer was changed to a mixed material (IrV) in which iridium (Ir) and vanadium (V) were homogeneous at an atomic number ratio of 65:35, and a film was formed to have a film thickness of 45 nm. A reflective photomask of Example 44 was manufactured by the same method as in Example 1 except for the above.

The refractive index n and the extinction coefficient k of the absorption layer at a wavelength of 13.5 nm in Example 44, in which the formation was performed as described above, were n = 0.918 and k = 0.038, respectively.

In addition, the absolute reflectivity of the absorption layer at a wavelength of 13.5 nm was 3.4%, and the phase difference was 201 degrees.

### <Example 45>

The material of the absorption layer was changed to a mixed material (IrV) in which iridium (Ir) and vanadium (V) were homogeneous at an atomic number ratio of 90:10, and a film was formed to have a film thickness of 46 nm. A reflective photomask of Example 45 was manufactured by the same method as in Example 1 except for the above.

The refractive index n and the extinction coefficient k of the absorption layer at a wavelength of 13.5 nm in Example 45, in which the formation was performed as described above, were n = 0.909 and k = 0.043, respectively.

In addition, the absolute reflectivity of the absorption layer at a wavelength of 13.5 nm was 2.2%, and the phase difference was 240 degrees.

### <Example 46>

The material of the absorption layer was changed to a mixed material (ReMo) in which rhenium (Re) and molybdenum (Mo) were homogeneous at an atomic number ratio of 45:55, and a film was formed to have a film thickness of 48 nm. A reflective photomask of Example 46 was manufactured by the same method as in Example 1 except for the above.

The refractive index n and the extinction coefficient k of the absorption layer at a wavelength of 13.5 nm in Example 46, in which the formation was performed as described above, were n = 0.920 and k = 0.021, respectively.

In addition, the absolute reflectivity of the absorption layer at a wavelength of 13.5 nm was 7.8%, and the phase difference was 213 degrees.

### <Example 47>

The material of the absorption layer was changed to a mixed material (ReMo) in which rhenium (Re) and molybdenum (Mo) were homogeneous at an atomic number ratio of 90:10, and a film was formed to have a film thickness of 47 nm. A reflective photomask of Example 47 was manufactured by the same method as in Example 1 except for the above.

The refractive index n and the extinction coefficient k of the absorption layer at a wavelength of 13.5 nm in Example 47, in which the formation was performed as described above, were n = 0.916 and k = 0.037, respectively.

In addition, the absolute reflectivity of the absorption layer at a wavelength of 13.5 nm was 2.5%, and the phase difference was 234 degrees.

### <Example 48>

The material of the absorption layer was changed to a mixed material (ReW) in which rhenium (Re) and tungsten (W) were homogeneous at an atomic number ratio of 75:25, and a film was formed to have a film thickness of 46 nm. A reflective photomask of Example 48 was manufactured by the same method as in Example 1 except for the above.

The refractive index n and the extinction coefficient k of the absorption layer at a wavelength of 13.5 nm in Example 48, in which the formation was performed as described above, were n = 0.920 and k = 0.038, respectively.

In addition, the absolute reflectivity of the absorption layer at a wavelength of 13.5 nm was 2.4%, and the phase difference was 216 degrees.

### <Example 49>

The material of the absorption layer was changed to a mixed material (ReW) in which rhenium (Re) and tungsten (W) were homogeneous at an atomic number ratio of 95:5, and a film was formed to have a film thickness of 46 nm. A reflective photomask of Example 49 was manufactured by the same method as in Example 1 except for the above.

The refractive index n and the extinction coefficient k of the absorption layer at a wavelength of 13.5 nm in Example 49, in which the formation was performed as described above, were n = 0.916 and k = 0.040, respectively.

In addition, the absolute reflectivity of the absorption layer at a wavelength of 13.5 nm was 2.8%, and the phase difference was 227 degrees.

### <Example 50>

The material of the absorption layer was changed to a mixed material (ReNb) in which rhenium (Re) and niobium (Nb) were homogeneous at an atomic number ratio of 75:25, and a film was formed to have a film thickness of 48 nm. A reflective photomask of Example 50 was manufactured by the same method as in Example 1 except for the above.

The refractive index n and the extinction coefficient k of the absorption layer at a wavelength of 13.5 nm in Example 50, in which the formation was performed as described above, were n = 0.920 and k = 0.031, respectively.

In addition, the absolute reflectivity of the absorption layer at a wavelength of 13.5 nm was 2.5%, and the phase difference was 213 degrees.

### <Example 51>

The material of the absorption layer was changed to a mixed material (ReNb) in which rhenium (Re) and niobium (Nb) were homogeneous at an atomic number ratio of 90:10, and a film was formed to have a film thickness of 46 nm. A reflective photomask of Example 51 was manufactured by the same method as in Example 1 except for the above.

The refractive index n and the extinction coefficient k of the absorption layer at a wavelength of 13.5 nm in Example 51, in which the formation was performed as described above, were n = 0.917 and k = 0.037, respectively.

In addition, the absolute reflectivity of the absorption layer at a wavelength of 13.5 nm was 4%, and the phase difference was 224 degrees.

### <Comparative Example 1>

In Comparative Example 1, a photomask of the related art including an existing film using tantalum (Ta) as a main material was used. In Comparative Example 1, an absorption layer was formed using tantalum nitride (TaN) to have a film thickness of 58 nm, and an outermost layer was formed using tantalum oxide (TaO) to have a film thickness of 2 nm to manufacture a reflective photomask. A reflective photomask of Comparative Example 1 was manufactured by the same method as in Example 1 except for the above.

The absolute reflectivity of the absorption layer at a wavelength of 13.5 nm of Comparative Example 1, in which the formation was performed as described above, was 1.3%, and the phase difference was 160 degrees.

### <Comparative Example 2>

The material of the absorption layer was changed to a mixed material (RhAl) in which rhodium (Rh) and aluminum (Al) were homogeneous at an atomic number ratio of 60:40, and a film was formed to have a film thickness of 47 nm. A reflective photomask of Comparative Example 2 was manufactured by the same method as in Example 1 except for the above.

The refractive index n and the extinction coefficient k of the absorption layer at a wavelength of 13.5 nm in Comparative Example 2, in which the formation was performed as described above, were n = 0.932 and k = 0.03, respectively.

In addition, the absolute reflectivity of the absorption layer at a wavelength of 13.5 nm was 3.1%, and the phase difference was 180 degrees.

### <Comparative Example 3>

A composition of RhAl, which is the material of the absorption layer, was changed to have an atomic number ratio of Rh:Al = 89:11 and a film was formed to have a film thickness of 47 nm. A reflective photomask of Comparative Example 3 was manufactured by the same method as in Example 1 except for the above.

The refractive index n and the extinction coefficient k of the absorption layer at a wavelength of 13.5 nm in Comparative Example 3, in which the formation was performed as described above, were n = 0.892 and k = 0.03, respectively.

In addition, the absolute reflectivity of the absorption layer at a wavelength of 13.5 nm was 6.3%, and the phase difference was 285 degrees.

### <Evaluation>

For the reflective photomasks obtained in Examples 1 to 51 and Comparative Examples 1 to 3 described above, the transfer performance was evaluated by the following method. The transfer performance was confirmed by a wafer exposure evaluation. In addition, the resolution was evaluated by a normalized image log-slope (NILS) value.

By using an EUV exposure apparatus (NXE3300B: manufactured by ASML), an absorption pattern of the reflective photomask manufactured in each of the examples and the comparative examples was transferred and exposed on a semiconductor wafer to which an EUV positive type and chemical amplification type resist was applied. At this time, an exposure amount was adjusted such that a hole pattern was transferred to 19 nm as designed. After that, the transferred resist pattern was observed and a line width thereof was measured by an electron beam dimension measuring machine, the resolution was confirmed, and the evaluation was performed based on four levels of "⊚", "∘", "Δ", and "x" as follows.

### <Evaluation criteria>

⊚: Case where the NILS value is more than 2.73
∘: Case where the NILS value is 2.48 or more and 2.73 or less
Δ: Case where the NILS value is 2.40 or more and less than 2.48
x: Case where the NILS value is less than 2.40

Table 1 shows the above evaluation results.

For the NILS value, when the evaluation was "o" or higher, it was evaluated as pass, because there was no problem with the transfer performance.

**[Table 1]**

| | Material (composition) | Film thickness (nm) | n | k | Phase difference (degree) | Reflectivity (%) | NILS | Evaluation |
|---|---|---|---|---|---|---|---|---|
| Ex. 1 | RhAI (Al 34%) | 47 | 0.924 | 0.03 | 205 | 3.4 | 2.66 | ○ |
| Ex. 2 | RhAI (Al 30%) | 47 | 0.919 | 0.03 | 220 | 3.7 | 2.73 | ○ |
| Ex. 3 | RhAI (Al 25%) | 47 | 0.912 | 0.03 | 240 | 4.3 | 2.76 | ⊚ |
| Ex. 4 | RhAI (Al 18%) | 47 | 0.902 | 0.03 | 265 | 5.3 | 2.67 | ○ |
| Ex. 5 | RhAI (Al 14%) | 47 | 0.896 | 0.03 | 275 | 5.9 | 2.56 | ○ |
| Ex. 6 | RhAI (Al 33%) | 54 | 0.923 | 0.03 | 240 | 2.6 | 2.74 | ⊚ |
| Ex. 7 | RhAI (Al 16%) | 41 | 0.899 | 0.03 | 240 | 4.4 | 2.78 | ⊚ |
| Ex. 8 | RhAI (Al 2%) | 38 | 0.878 | 0.03 | 240 | 9.2 | 2.71 | ○ |
| Ex. 9 | Rh | 33 | 0.875 | 0.03 | 240 | 11.0 | 2.53 | ○ |
| Ex. 10 | RuNb (Nb 15%) | 44 | 0.895 | 0.015 | 240 | 17.0 | 2.48 | ○ |
| Ex. 11 | RuAI (AI 41%) | 73 | 0.940 | 0.023 | 240 | 3.7 | 2.73 | ○ |
| Ex. 12 | SnRuO (Ru 80%) | 42 | 0.896 | 0.03 | 240 | 3.1 | 2.78 | ⊚ |
| Ex. 13 | SnRuO (Ru 80%) | 39 | 0.896 | 0.03 | 225 | 8.9 | 2.65 | ○ |
| Ex. 14 | InRuO (Ru 85%) | 42 | 0.895 | 0.03 | 240 | 3.3 | 2.78 | ⊚ |
| Ex. 15 | InRuO (Ru 85%) | 39 | 0.895 | 0.03 | 225 | 9.3 | 2.64 | ○ |
| Ex. 16 | TaTi (Ti 40%) | 78 | 0.947 | 0.030 | 212 | 1.2 | 2.48 | ○ |
| Ex. 17 | Ti | 80 | 0.952 | 0.014 | 212 | 6.5 | 2.56 | ○ |
| Ex. 18 | MoPd (Pd 60%) | 45 | 0.896 | 0.030 | 235 | 6.6 | 2.76 | ⊚ |
| Ex. 19 | Pt | 45 | 0.890 | 0.060 | 243 | 1.3 | 2.72 | ○ |
| Ex. 20 | IrPt (Pt 25%) | 45 | 0.902 | 0.049 | 234 | 2.2 | 2.74 | ⊚ |
| Ex. 21 | IrAu (Au 60%) | 45 | 0.901 | 0.049 | 234 | 2.2 | 2.74 | ⊚ |
| Ex. 22 | RePt (Pt 25%) | 46 | 0.909 | 0.045 | 240 | 2.2 | 2.75 | ⊚ |
| Ex. 23 | ReAu (Au 60%) | 45 | 0.905 | 0.047 | 227 | 2.8 | 2.74 | ⊚ |
| Ex. 24 | PtMo (Mo 80%) | 48 | 0.918 | 0.017 | 213 | 7.8 | 2.65 | ○ |
| Ex. 25 | PtMo (Mo 20%) | 45 | 0.898 | 0.049 | 234 | 2.2 | 2.74 | ⊚ |
| Ex. 26 | PtNb (Nb 65%) | 47 | 0.919 | 0.024 | 214 | 6.0 | 2.68 | ○ |
| Ex. 27 | PtNb (Nb 20%) | 45 | 0.900 | 0.049 | 234 | 2.2 | 2.74 | ⊚ |
| Ex. 28 | AuMo (Mo 75%) | 49 | 0.918 | 0.018 | 209 | 7.6 | 2.63 | ○ |
| Ex. 29 | AuMo (Mo 5%) | 39 | 0.900 | 0.050 | 228 | 2.7 | 2.75 | ⊚ |
| Ex. 30 | AuNb (Nb 55%) | 48 | 0.918 | 0.026 | 213 | 4.5 | 2.71 | ○ |
| Ex. 31 | AuNb (Nb 10%) | 45 | 0.903 | 0.047 | 234 | 2.2 | 2.74 | ⊚ |
| Ex. 32 | AuTi (Ti 35%) | 47 | 0.918 | 0.039 | 225 | 1.3 | 2.69 | ○ |
| Ex. 33 | AuTi (Ti 15%) | 46 | 0.907 | 0.046 | 240 | 2.2 | 2.75 | ⊚ |
| Ex. 34 | AuZr (Zr 30%) | 51 | 0.917 | 0.038 | 218 | 2.1 | 2.67 | ○ |
| Ex. 35 | AuZr (Zr 10%) | 46 | 0.905 | 0.047 | 248 | 2.5 | 2.74 | ⊚ |
| Ex. 36 | IrMo (Mo 70%) | 49 | 0.918 | 0.018 | 209 | 7.6 | 2.63 | ○ |
| Ex. 37 | IrMo (Mo 10%) | 45 | 0.907 | 0.041 | 227 | 3.7 | 2.74 | ⊚ |
| Ex. 38 | IrW(W50%) | 47 | 0.919 | 0.039 | 225 | 1.3 | 2.69 | ○ |
| Ex. 39 | IrW (W 10%) | 46 | 0.908 | 0.044 | 240 | 2.2 | 2.75 | ⊚ |
| Ex. 40 | IrNb (Nb 50%) | 47 | 0.920 | 0.025 | 214 | 6.0 | 2.68 | ○ |
| Ex. 41 | IrNb (Nb 10%) | 46 | 0.908 | 0.041 | 237 | 3.1 | 2.76 | ⊚ |
| Ex. 42 | IrTa (Ta 15%) | 45 | 0.911 | 0.044 | 219 | 2.8 | 2.71 | ○ |
| Ex. 43 | IrTa (Ta 5%) | 46 | 0.907 | 0.045 | 248 | 2.5 | 2.74 | ⊚ |
| Ex. 44 | IrV (V 35%) | 45 | 0.918 | 0.038 | 201 | 3.4 | 2.60 | ○ |
| Ex. 45 | IrV (V 10%) | 46 | 0.909 | 0.043 | 240 | 2.2 | 2.75 | ⊚ |
| Ex. 46 | ReMo (Mo 55%) | 48 | 0.920 | 0.021 | 213 | 7.8 | 2.65 | ○ |
| Ex. 47 | ReMo (Mo 10%) | 47 | 0.916 | 0.037 | 234 | 2.5 | 2.75 | ⊚ |
| Ex. 48 | ReW (W 25%) | 46 | 0.920 | 0.038 | 216 | 2.4 | 2.71 | ○ |
| Ex. 49 | ReW (W 5%) | 46 | 0.916 | 0.040 | 227 | 2.8 | 2.74 | ⊚ |
| Ex. 50 | ReNb (Nb 25%) | 48 | 0.920 | 0.031 | 213 | 2.5 | 2.70 | ○ |
| Ex. 51 | ReNb (Nb 10%) | 46 | 0.917 | 0.037 | 224 | 4.0 | 2.74 | ⊚ |
| Comp. Ex. 1 | TaN + TaO | 60 | 0.950 | 0.03 | 160 | 1.3 | 2.37 | x |
| Comp. Ex. 2 | RhAI (Al 40%) | 47 | 0.932 | 0.03 | 180 | 3.1 | 2.47 | Δ |
| Comp. Ex. 3 | RhAI (Al 11%) | 47 | 0.892 | 0.03 | 285 | 6.3 | 2.47 | Δ |

Table 1 shows the evaluation results of Examples 1 to 51 and Comparative Examples 1 to 3.

In Comparative Example 1 including the tantalum (Ta)-based absorption layer of the related art having a film thickness of 60 nm, the phase difference was 160 degrees and the NILS was 2.37. It was found that, in a case where the phase difference of the absorption pattern layers is 200 degrees or more and 280 degrees or less as in Examples 1 to 51, the NILS was great and the resolution was improved, compared to Comparative Example 1.

In addition, it was found that, in Examples 1 to 51 in which the phase difference was 200 degrees or more and 280 degrees or less, the NILS was great and the resolution was improved, even when compared with Comparative Example 2 in which the phase difference was 180 degrees and Comparative Example 3 in which the phase difference was 285 degrees.

Hereinafter, a result of comparing NILS of the examples and the comparative examples will be described in detail with reference to Table 1 and the graph illustrated in FIG. 9.

As illustrated in Examples 1 to 5 and Comparative Examples 2 and 3 of FIG. 9 and Table 1, the value of NILS is 2.47 in Comparative Example 2 in which the film thickness is 47 nm and the phase difference of the absorption pattern layer 14a formed of RhAl is 180 degrees. In contrast, the value of NILS is 2.66 in Example 1 in which the phase difference is 205 degrees, and the value is approximately 7% higher than that in a case where the phase difference is 180 degrees (Comparative Example 2).

In addition, the value of NILS is 2.73 in Example 2 in which the phase difference is 220 degrees, and the value is approximately 10% higher than that in a case where the phase difference is 180 degrees (Comparative Example 2).

In addition, the value of NILS is 2.76 in Example 3 in which the phase difference is 240 degrees, and the value is approximately 12% higher than that in a case where the phase difference is 180 degrees (Comparative Example 2).

In addition, the value of NILS is 2.67 in Example 4 in which the phase difference is 265 degrees, and the value is approximately 8% higher than that in a case where the phase difference is 180 degrees (Comparative Example 2).

In addition, the value of NILS is 2.56 in Example 5 in which the phase difference is 275 degrees, and the value is approximately 4% higher than that in a case where the phase difference is 180 degrees (Comparative Example 2).

On the other hand, the value of NILS is 2.46 in Comparative Example 3 in which the phase difference is 285 degrees, and is substantially the same value as that in a case where the phase difference is 180 degrees (Comparative Example 2).

In addition, as illustrated in Example 6 of FIG. 9 and Table 1, the value of NILS is 2.74 in Example 6 in which, in a case where the film thickness of the absorption pattern layer 14a is 54 nm, the phase difference is 240 degrees, and the value is approximately 10% higher than that in a case where the phase difference is 180 degrees with the same film thickness.

In addition, as illustrated in Example 7 of FIG. 9 and Table 1, the value of NILS is 2.78 in Example 7 in which, in a case where the film thickness of the absorption pattern layer 14a is 41 nm, the phase difference is 240 degrees, and the value is approximately 13% higher than that in a case where the phase difference is 180 degrees with the same film thickness.

In addition, as illustrated in Example 8 of FIG. 9 and Table 1, the value of NILS is 2.71 in Example 8 in which, in a case where the film thickness of the absorption pattern layer 14a is 38 nm, the phase difference is 240 degrees, and the value is approximately 31% higher than that in a case where the phase difference is 180 degrees with the same film thickness.

From the above, in order to improve the resolution, the phase difference is preferably in a range of 200 degrees or more and 280 degrees or less, more preferably in a range of 215 degrees or more and 270 degrees or less, and most preferably in a range of 230 degrees or more and 260 degrees or less.

That is, a range of suitable phase difference of the absorption layer in the reflective mask is largely different from "within a range of 170 degrees or more and 190 degrees or less" used in a design concept of the related art, and is "in a range of 200 degrees or more and 280 degrees or less".

The NILS is 2.53 in Example 9 in which rhodium (Rh) having a film thickness of 33 nm was formed and the phase difference was 240 degrees, and the NILS was 2.48 in Example 10 in which the formation was performed with a material containing ruthenium (Ru) and niobium (Nb) to have an atomic number ratio of 85:15 with a film thickness of 44 nm, and the phase difference was 240 degrees.

Examples 6 to 10 showed a case where the reflectivity is respectively 2.6%, 4.4%, 9.2%, 11.0%, and 17.0%, however, transferability that is more excellent than each comparative example in all cases, regardless of the reflectivity. From this, it is found that a sufficient phase shift effect is obtained and the resolution is improved in a case where the reflectivity is in a range of 2% or more and 20% or less.

The NILS was 2.73 in Example 11 in which the formation was performed with a material containing ruthenium (Ru) and aluminum (Al) to have an atomic number ratio of 59:41 with a film thickness of 72 nm, and the phase difference was 240 degrees. In Example 11, the refractive index n is as high as 0.94. Accordingly, the film thickness is more than 60 nm which is the film thickness of the film of the related art of Comparative Example 1, and the shadowing effect could not be reduced, however, the NILS was excellent due to the phase shift effect.

The NILS was 2.78 in Example 12 in which the formation was performed with a material containing tin oxide (SnO) and ruthenium (Ru) to have an atomic number ratio of 20:80 with a film thickness of 42 nm, and the phase difference was 240 degrees, the NILS was 2.65 in Example 13 in which the formation was performed with a material containing tin oxide (SnO) and ruthenium (Ru) to have an atomic number ratio of 20:80 with a film thickness of 39 nm, and the phase difference was 225 degrees, the NILS was 2.78 in Example 14 in which the formation was performed with a material containing indium oxide (InO) and ruthenium (Ru) to have an atomic number ratio of 15:85 with a film thickness of 42 nm, and the phase difference was 240 degrees, and the NILS was 2.64 in Example 15 in which the formation was performed with a material containing indium oxide (InO) and ruthenium (Ru) to have an atomic number ratio of 15:85 with a film thickness of 39 nm, and the phase difference was 225 degrees.

Even in a case where the absorption layer 14 (the absorption pattern layer 14a) was formed with a material containing tin (Sn) or indium (In) having excellent processability as described above, the phase shift effect was obtained and the resolution was improved.

The NILS was 2.48 in Example 16 in which the formation was performed with a material containing tantalum (Ta) and titanium (Ti) to have an atomic number ratio of 60:40 with a film thickness of 78 nm, and the phase difference was 212 degrees, and the NILS was 2.56 in Example 17 in which the formation was performed with titanium (Ti) with a film thickness of 80 nm, and the phase difference was 212 degrees. In Examples 16 and 17, the refractive index n is relatively high as 0.947 and 0.952. Accordingly, the film thickness is more than 60 nm which is the film thickness of the film of the related art of Comparative Example 1, and the shadowing effect could not be reduced, however, the NILS was excellent due to the phase shift effect. In addition, the reflectivity of Examples 16 and 17 were respectively 1.2% and 6.5%, and Example 17 in which the reflectivity was in a range of 2% or more and 20% or less, had more excellent NILS.

The NILS was 2.76 in Example 18 in which the formation was performed with a material containing molybdenum (Mo) and palladium (Pd) to have an atomic number ratio of 40:60 with a film thickness of 45 nm, and the phase difference was 235 degrees, and the NILS was 2.72 in Example 19 in which the formation was performed with platinum (Pt) with a film thickness of 45 nm, and the phase difference was 243 degrees. In both Examples 18 and 19, the NILS was excellent due to the phase shift effect. In addition, the reflectivity of Examples 18 and 19 were respectively 6.6% and 1.3%, and Example 18 in which the reflectivity was in a range of 2% or more and 20% or less, had more excellent NILS.

The NILS was 2.74 in Example 20 in which the formation was performed with a material containing iridium (Ir) and platinum (Pt) to have an atomic number ratio of 75:25 with a film thickness of 45 nm, and the phase difference was 234 degrees, the NILS was 2.74 in Example 21 in which the formation was performed with a material containing iridium (Ir) and gold (Au) to have an atomic number ratio of 40:60 with a film thickness of 45 nm, and the phase difference was 234 degrees, the NILS was 2.75 in Example 22 in which the formation was performed with a material containing rhenium (Re) and platinum (Pt) to have an atomic number ratio of 75:25 with a film thickness of 46 nm, and the phase difference was 240 degrees, and the NILS was 2.74 in Example 23 in which the formation was performed with a material containing rhenium (Re) and gold (Au) to have an atomic number ratio of 40:60 with a film thickness of 45 nm, and the phase difference was 227 degrees.

As described above, even in a case where the absorption layer 14 (the absorption pattern layer 14a) configured with the elements of only the third material group having small refractive index n and excellent processability and hydrogen resistance was formed, the phase shift effect was obtained and the resolution was improved.

The NILS was 2.65 in Example 24 in which the formation was performed with a material containing platinum (Pt) and molybdenum (Mo) to have an atomic number ratio of 20:80 with a film thickness of 48 nm, and the phase difference was 213 degrees, and the NILS was 2.74 in Example 25 in which the formation was performed with a material containing platinum (Pt) and molybdenum (Mo) to have an atomic number ratio of 80:20 with a film thickness of 45 nm, and the phase difference was 234 degrees.

In addition, the NILS was 2.68 in Example 26 in which the formation was performed with a material containing platinum (Pt) and niobium (Nb) to have an atomic number ratio of 35:65 with a film thickness of 47 nm, and the phase difference was 214 degrees, and the NILS was 2.74 in Example 27 in which the formation was performed with a material containing platinum (Pt) and niobium (Nb) to have an atomic number ratio of 80:20 with a film thickness of 45 nm, and the phase difference was 234 degrees.

In addition, the NILS was 2.63 in Example 28 in which the formation was performed with a material containing gold (Au) and molybdenum (Mo) to have an atomic number ratio of 25:75 with a film thickness of 49 nm, and the phase difference was 209 degrees, and the NILS was 2.75 in Example 29 in which the formation was performed with a material containing gold (Au) and molybdenum (Mo) to have an atomic number ratio of 95:5 with a film thickness of 39 nm, and the phase difference was 228 degrees.

In addition, the NILS was 2.71 in Example 30 in which the formation was performed with a material containing gold (Au) and niobium (Nb) to have an atomic number ratio of 45:55 with a film thickness of 48 nm, and the phase difference was 213 degrees, and the NILS was 2.74 in Example 31 in which the formation was performed with a material containing gold (Au) and niobium (Nb) to have an atomic number ratio of 90:10 with a film thickness of 45 nm, and the phase difference was 234 degrees.

In addition, the NILS was 2.69 in Example 32 in which the formation was performed with a material containing gold (Au) and titanium (Ti) to have an atomic number ratio of 65:35 with a film thickness of 47 nm, and the phase difference was 225 degrees, and the NILS was 2.75 in Example 33 in which the formation was performed with a material containing gold (Au) and titanium (Ti) to have an atomic number ratio of 85:15 with a film thickness of 46 nm, and the phase difference was 240 degrees.

In addition, the NILS was 2.67 in Example 34 in which the formation was performed with a material containing gold (Au) and zirconium (Zr) to have an atomic number ratio of 70:30 with a film thickness of 51 nm, and the phase difference was 218 degrees, and the NILS was 2.74 in Example 35 in which the formation was performed with a material containing gold (Au) and zirconium (Zr) to have an atomic number ratio of 90:10 with a film thickness of 46 nm, and the phase difference was 248 degrees.

In addition, the NILS was 2.63 in Example 36 in which the formation was performed with a material containing iridium (Ir) and molybdenum (Mo) to have an atomic number ratio of 30:70 with a film thickness of 49 nm, and the phase difference was 209 degrees, and the NILS was 2.74 in Example 37 in which the formation was performed with a material containing iridium (Ir) and molybdenum (Mo) to have an atomic number ratio of 90:10 with a film thickness of 45 nm, and the phase difference was 227 degrees.

In addition, the NILS was 2.69 in Example 38 in which the formation was performed with a material containing iridium (Ir) and tungsten (W) to have an atomic number ratio of 50:50 with a film thickness of 47 nm, and the phase difference was 225 degrees, and the NILS was 2.75 in Example 39 in which the formation was performed with a material containing iridium (Ir) and tungsten (W) to have an atomic number ratio of 90:10 with a film thickness of 46 nm, and the phase difference was 240 degrees.

In addition, the NILS was 2.68 in Example 40 in which the formation was performed with a material containing iridium (Ir) and niobium (Nb) to have an atomic number ratio of 50:50 with a film thickness of 47 nm, and the phase difference was 214 degrees, and the NILS was 2.76 in Example 41 in which the formation was performed with a material containing iridium (Ir) and niobium (Nb) to have an atomic number ratio of 90:10 with a film thickness of 46 nm, and the phase difference was 237 degrees.

In addition, the NILS was 2.71 in Example 42 in which the formation was performed with a material containing iridium (Ir) and tantalum (Ta) to have an atomic number ratio of 85:15 with a film thickness of 45 nm, and the phase difference was 219 degrees, and the NILS was 2.74 in Example 43 in which the formation was performed with a material containing iridium (Ir) and tantalum (Ta) to have an atomic number ratio of 95:5 with a film thickness of 46 nm, and the phase difference was 248 degrees.

In addition, the NILS was 2.6 in Example 44 in which the formation was performed with a material containing iridium (Ir) and vanadium (V) to have an atomic number ratio of 65:35 with a film thickness of 45 nm, and the phase difference was 201 degrees, and the NILS was 2.75 in Example 45 in which the formation was performed with a material containing iridium (Ir) and vanadium (V) to have an atomic number ratio of 90:10 with a film thickness of 46 nm, and the phase difference was 240 degrees.

In addition, the NILS was 2.65 in Example 46 in which the formation was performed with a material containing rhenium (Re) and molybdenum (Mo) to have an atomic number ratio of 45:55 with a film thickness of 48 nm, and the phase difference was 213 degrees, and the NILS was 2.75 in Example 47 in which the formation was performed with a material containing rhenium (Re) and molybdenum (Mo) to have an atomic number ratio of 90:10 with a film thickness of 47 nm, and the phase difference was 234 degrees.

In addition, the NILS was 2.71 in Example 48 in which the formation was performed with a material containing rhenium (Re) and tungsten (W) to have an atomic number ratio of 75:25 with a film thickness of 46 nm, and the phase difference was 216 degrees, and the NILS was 2.74 in Example 49 in which the formation was performed with a material containing rhenium (Re) and tungsten (W) to have an atomic number ratio of 95:5 with a film thickness of 46 nm, and the phase difference was 227 degrees.

In addition, the NILS was 2.7 in Example 50 in which the formation was performed with a material containing rhenium (Re) and niobium (Nb) to have an atomic number ratio of 75:25 with a film thickness of 48 nm, and the phase difference was 213 degrees, and the NILS was 2.74 in Example 51 in which the formation was performed with a material containing rhenium (Re) and niobium (Nb) to have an atomic number ratio of 90:10 with a film thickness of 46 nm, and the phase difference was 224 degrees.

As described above, even in a case where the absorption layer 14 (the absorption pattern layer 14a) was formed with the material including the elements of the fourth material group having excellent processability and hydrogen resistance, in addition to the elements of the third material group having a small refractive index n, the phase shift effect was obtained and the resolution was improved. In addition, in a case where a content ratio of the elements in the third material group was 20 atom% or more of the elements of the entire absorption layer 14, the NILS was excellent. In addition, in a case where the combination of the elements of the third material group and the elements of the fourth material group included in the absorption layer 14 is the same, the NILS was more excellent, as the content ratio of the elements of the third material group is great.

The reflective photomask blank and the reflective photomask of the present disclosure are not limited to the embodiments and the examples described above, and various modifications can be made within a range not impairing the features of the invention.

### Industrial Applicability

The reflective photomask blank and the reflective photomask according to the present invention can be suitably used to form a nanofabrication pattern by the EUV exposure in the manufacturing step such as a semiconductor integrated circuit or the like.

### Reference Signs List

- 11: substrate
- 12: reflective layer
- 13: protective layer
- 14: absorption layer
- 14a: absorption pattern (absorption pattern layer)
- 15: back surface conductive film
- 16: resist film
- 16a: resist pattern
- 100: reflective photomask blank
- 200: reflective photomask

## Claims

1. A reflective photomask blank comprising:
a substrate;
a reflective layer having a multi-layer film structure, formed on the substrate, and configured to reflect an EUV light;
a protective layer formed on the reflective layer and configured to protect the reflective layer; and
an absorption layer formed on the protective layer and configured to absorb the EUV light,
wherein the absorption layer has a phase difference in a range of 200 degrees or more and 280 degrees or less.

2. The reflective photomask blank according to claim 1, wherein the absorption layer has a phase difference in a range of 215 degrees or more and 270 degrees or less.

3. The reflective photomask blank according to claim 1, wherein the absorption layer has a phase difference in a range of 230 degrees or more and 260 degrees or less.

4. The reflective photomask blank according to any one of claims 1 to 3, wherein the absorption layer has a refractive index n with respect to the EUV light less than 0.93.

5. The reflective photomask blank according to any one of claims 1 to 3, wherein the absorption layer has a refractive index n with respect to the EUV light less than 0.92.

6. The reflective photomask blank according to any one of claims 1 to 5, wherein the absorption layer is configured with a material containing at least one or more elements of Ru, Rh, Mo, Pd, Ag, Pt, Au, Os, Ir, and Re.

7. The reflective photomask blank according to any one of claims 1 to 6, wherein the absorption layer has a reflectivity with respect to the EUV light in a range of 2% or more and 20% or less.

8. The reflective photomask blank according to any one of claims 1 to 7, wherein the absorption layer is configured with a material containing at least one or more elements of Pt, Au, Ir, and Re.

9. The reflective photomask blank according to claim 6 or 8, wherein the absorption layer further contains at least one or more elements of Mo, W, Nb, Hg, Fe, Ta, V, Bi, Ti, Zr, Hf, C, B, Be, and Al.

10. A reflective photomask comprising:
a substrate;
a reflective layer having a multi-layer film structure, formed on the substrate, and configured to reflect an EUV light;
a protective layer formed on the reflective layer and configured to protect the reflective layer; and
an absorption pattern layer formed on the protective layer, formed with a pattern, and configured to absorb the EUV light,
wherein the absorption pattern layer has a phase difference in a range of 200 degrees or more and 280 degrees or less.

11. The reflective photomask according to claim 10, wherein the absorption pattern layer has a phase difference in a range of 215 degrees or more and 270 degrees or less.

12. The reflective photomask according to claim 10, wherein the absorption pattern layer has a phase difference in a range of 230 degrees or more and 260 degrees or less.

13. The reflective photomask according to any one of claims 10 to 12, wherein the absorption pattern layer has a refractive index n with respect to the EUV light less than 0.93.

14. The reflective photomask according to any one of claims 10 to 12, wherein the absorption pattern layer has a refractive index n with respect to the EUV light less than 0.92.

15. The reflective photomask according to any one of claims 10 to 14, wherein the absorption pattern layer is configured with a material containing at least one or more elements of Ru, Rh, Mo, Pd, Ag, Pt, Au, Os, Ir, and Re.

16. The reflective photomask according to any one of claims 10 to 15, wherein the absorption pattern layer has a reflectivity with respect to the EUV light in a range of 2% or more and 20% or less.

17. The reflective photomask according to any one of claims 10 to 16, wherein the absorption pattern layer is configured with a material containing at least one or more elements of Pt, Au, Ir, and Re.

18. The reflective photomask according to claim 15 or 17, wherein the absorption pattern layer further contains at least one or more elements of Mo, W, Nb, Hg, Fe, Ta, V, Bi, Ti, Zr, Hf, C, B, Be, and Al.
